# EUROPÄISCHE PATENTANMELDUNG

(11) **EP 4 064 813 A1**
(43) Veröffentlichungstag der Anmeldung: **28.09.2022**
(21) Anmeldenummer: 21165315.9
(22) Anmeldetag: 26.03.2021
(51) Int. Cl.: H05K 13/08, H05K 13/04, G01B 11/25, G01B 11/245, B41F 15/26

(54) **VERFAHREN ZUR ÜBERWACHUNG EINER SMD-FERTIGUNG UND SMD-FERTIGUNGSSTRASSE**

(71) Anmelder: Siemens Aktiengesellschaft, 80333 München (DE)
(72) Erfinder: Blank, Rene, 12249 Berlin (DE); Hanisch, Michael, 16540 Hohen Neuendorf (DE); Nerreter, Stefan, 15754 Heidesee OT Blossin (DE); Sommerfeld, Dennis, 12347 Berlin (DE); Wittreich, Ulrich, 16727 Velten (DE)

(57) **Zusammenfassung**

Um zur Überwachung einer SMD-Fertigung eine Pre-Prozess-Inline-Flachbaugruppen-Qualitätskontrolle durchführen zu können, wird es im Zuge der SMD-Fertigung mit mindestens eines Fertigungslinie (FL), bei der eine Flachbaugruppe (FBG), insbesondere eine Leiterplatte (LP), für eine fertigungslinienbezogene SMD-Bestückung einem Schablonendrucksystem (SDS1, SDS2) zuführbar ist, vorgeschlagen, einerseits Höhenunterschiede (HU1, HU2, HU3) der Flachbaugruppe (FBG, LP), die durch kontaktlose Abstandsmessung (AM) erfassbar sind, in einem Einlaufbereich eines ersten Schablonendrucksystems (SDS1), wenn die Flachbaugruppe (FBG, LP) dem ersten Schablonendrucksystem (SDS1) zugeführt wird, oder in dem ersten Schablonendrucksystem (SDS1) zur Ermittlung von die Höhenunterschiede (HU1, HU2, HU3) repräsentierenden, abstandsmessungsbasierten Erfassungsdaten (EFD_{AM}) zu erfassen und andererseits - als Alternative - Höhenunterschiede (HU1) der Flachbaugruppe (FBG, LP), die durch Kraft-/Abstandsmessung (KAM) erfassbar sind, in einem zweiten Schablonendrucksystem (SDS2) zur Ermittlung von die Höhenunterschiede (HU4) repräsentierenden, kraft-/abstandsmessungs-basierten Erfassungsdaten (EFD_{RAM}) zu erfassen.

## Beschreibung

Die Erfindung bezieht sich auf ein Verfahren zur Überwachung einer SMD-Fertigung gemäß dem Oberbegriff des Patentanspruches 1 und eine SMD-Fertigungsstraße gemäß dem Oberbegriff des Patentanspruches 9.

In einer "Service-Mounted Device <SMD>"-Fertigung, auch als Elektronikmontage bezeichnet, werden in einer SMD-Fertigungsstraße mit mindestens einer Fertigungslinie Flachbaugruppen, z.B. Leiterplatten, für eine SMD-Bestückung einem Schablonendrucksystem zum Lotpastenauftrag zugeführt. Dieser Auftrag von Lotpaste oder anderen Stoffen oder Medien, wie z.B. Kleber, Lacke, Sinterpasten, etc., auf den Flachbaugruppen bzw. Leiterplatten erfolgt in einem schnellen, hochautomatisierten Prozess mittels Drucken.

Um für einen solchen Prozess sicherstellen zu können, dass dieser bei unterschiedlichen Fertigungsbedingungen mit potenziellen Fehlerquellen für die Fertigung von SMD-bestückten Flachbaugruppen bzw. Leiterplatten den Ansprüchen an Qualität in Bezug auf Funktionstauglichkeit der SMD-bestückten Flachbaugruppe bzw. Leiterplatte genügt, sind gemäß dem Stand der Technik stichprobenartige Qualitätskontrollen vorgesehen.

Unterschiedliche Fertigungsbedingungen mit potenziellen Fehlerquellen für die Fertigung von SMD-bestückten Flachbaugruppen bzw. Leiterplatten liegen z.B. dann vor, wenn
- die Flachbaugruppen bzw. Leiterplatten von verschiedenen Lieferanten und/oder aus verschiedenen Herstellungschargen stammen,
- eine auf die Flachbaugruppen bzw. Leiterplatten aufgetragene Lötstopplackschicht starken Prozessschwankungen unterworfen ist,
- es durch einen ersten Lötprozess auf einer ersten Seite einer doppelseitig zu bestückenden Flachbaugruppe bzw. Leiterplatte zu Verwölbungen der Flachbaugruppe bzw. Leiterplatte kommt, welche sich negativ und qualitätsbeeinflussend auf den Druck, die Bestückung und den Lötprozess für eine zweite Seite der Flachbaugruppe bzw. Leiterplatte auswirken können.

Bisher gibt es nur die stichprobenartigen Qualitätskontrollen, die in der Regel an separaten Systemen außerhalb des normalen Fertigungsflusses in der SMD-Fertigungsstraße erfolgen. Deshalb werden auftretende Fehler häufig nicht erkannt und führen zu hohen Nacharbeitskosten.

Die der Erfindung zugrundeliegende Aufgabe besteht darin, ein Verfahren zur Überwachung einer SMD-Fertigung und SMD-Fertigungsstraße anzugeben, mit dem bzw. der eine Pre-Prozess-Inline-Flachbaugruppen-Qualitätskontrolle durchgeführt werden kann.

Diese Aufgabe wird ausgehend von dem im Oberbegriff des Patentanspruchs 1 definierten dem Verfahren durch die im Kennzeichen des Patentanspruches 1 angegebenen Merkmale gelöst.

Darüber hinaus wird die Aufgabe ausgehend von der im Oberbegriff des Patentanspruchs 9 definierten SMD-Fertigungsstraße durch die im Kennzeichen des Patentanspruches 9 angegebenen Merkmale gelöst.

Die der Erfindung gemäß den unabhängigen Ansprüchen 1 und 9 zugrundeliegenden Idee besteht darin, zur Überwachung einer SMD-Fertigung, bei dem im Zuge der SMD-Fertigung mit mindestens eines Fertigungslinie eine Flachbaugruppe, insbesondere eine Leiterplatte, für eine fertigungslinienbezogene SMD-Bestückung einem Schablonendrucksystem zuführbar ist, Höhenunterschiede der Flachbaugruppe, die durch kontaktlose Abstandsmessung erfassbar sind, in einem Einlaufbereich eines ersten Schablonendrucksystems, wenn die Flachbaugruppe dem ersten Schablonendrucksystem zugeführt wird, oder in dem ersten Schablonendrucksystem zur Ermittlung von die Höhenunterschiede repräsentierenden, abstandsmessungsbasierten Erfassungsdaten erfasst werden oder aber, alternativ dazu, Höhenunterschiede der Flachbaugruppe, die durch Kraft-/Abstandsmessung erfassbar sind, in einem zweiten Schablonendrucksystem zur Ermittlung von die Höhenunterschiede repräsentierenden, kraft-/abstandsmessungs-basierten Erfassungsdaten erfasst werden. Das Erfassen erfolgt dabei "inline" mit einem Inline-Sensorsystem, wie z.B. einer Abstand-Sensormesseinrichtung zur kontaktlosen Abstandsmessung oder einer Kraft-/Abstand-Sensormesseinrichtung zur Kraft-/Abstandsmessung.

Die sich hierbei, wenn die die SMD-Fertigung derartig überwacht wird, ergebenden Vorteile sind:
- Durch Nutzung der anfallenden Erfassungsdaten und gezielte Reaktion darauf können Fehlleistungskosten, z.B. Aufwände, die infolge von Reparaturen entstehen, reduziert oder sogar vermieden werden.
- Die Erfassung der Daten mit einem Inline-Sensorsystem führt zu keiner erhöhten Prozesszeit, wie sie sich z.B. bei einer stichprobenartigen Qualitätskontrolle oder zusätzlichen Überprüfungen der einzelnen Prozessschritte mittels einer "Solder Paste Inspection <SPI>"-Prüfroutine, einer "Automatic optical Inspection <AOI>"-Prüfroutine und/oder einer"Automatic X-Ray Inspection <AXI>"-Prüfroutine erfolgen. AOI-/SPI-Prüfroutinen ergeben würden.
- Durch Nutzung eines preisgünstigen Inline-Sensorsystems für die Abstandsmessung zu einem Punkt kann in Verbindung mit dem Weitertransport der Flachbaugruppe bzw. der Leiterplatte durch ein für die Zuführung der Flachbaugruppe bzw. der Leiterplatte verantwortliches Transportsystem ein kostengünstiger Linienscan für jede Flachbaugruppe bzw. Leiterplatte erzeugt werden. Dadurch können qualitätskritische Schwankungen der Eingangsqualität der Flachbaugruppen bzw. der Leiterplatten in einem sehr frühen Stadium des Fertigungsprozesses erkannt werden und somit rechtzeitig geeignete Maßnahmen abgeleitet und umgesetzt werden.
- Vorhandene und zusätzlich erfasste Erfassungsdaten werden wertschöpfend und qualitätsverbessernd genutzt.

Weiterhin ist gemäß den Ansprüchen 2 und 10 von Vorteil, wenn die kontaktlose Abstandmessung entweder als Triangulation optisch und winkelbasiert oder mittels Konfokaltechnik konfokal oder auf Prinzipien zur Musterprojektion oder auf Prinzipien zur Streifenprojektion oder Kamera-basiert durchgeführt wird.

Gemäß den vorteilhaften Weiterbildungen in den Ansprüchen 3 und 11 können solche, durch die kontaktlose Abstandsmessung erfassbare Höhenunterschiede erfasst werden, die durch Verwölbungen der Flachbaugruppe und/oder unterschiedliche Metallisierungsschichtdicken oder Lötstopplackschichtdicken der Flachbaugruppe hervorgerufen werden.

Alternativ dazu können gemäß den vorteilhaften Weiterbildungen in den Ansprüchen 4 und 12 können auch solche, durch die Kraft-/Abstandsmessung erfassbare Höhenunterschiede erfasst werden, die durch Verwölbungen der Flachbaugruppe hervorgerufen wird. Hierfür ist es gemäß den Ansprüchen 5 und 13 von Vorteil, die Kraft-/Abstandmessung in dem Schablonendrucksystem (SDS) für die Erfassung der Verwölbungen durch eine Abstandshalterung für die Flachbaugruppe unterstützt wird.

Bei den Erfassungsdaten ist es gemäß den Weiterbildungen in den Ansprüchen 6 und 14 vorteilhaft, wenn diese durch eine Analysesoftware bezüglich der auftretenden Höhenunterschiede analysiert und Hinweisinformationen für einen Bediener oder einer Prozesssteuerung der SMD-Fertigung für Eingriffe in diese generiert werden. Hierbei ist es gemäß den Weiterbildungen in den Ansprüchen 7 und 15 von Vorteil, dass die Hinweisinformationen durch Vergleich der Erfassungsdaten (von unterschiedlichen Flachbaugruppe, insbesondere aus verschiedenen SMD-Fertigungslinien, und daraus sich ergebende Auffälligkeiten der Flachbaugruppe detektiert, analysiert, gemeldet und/oder dynamisch korrigiert werden.

Dazu es gemäß den Weiterbildungen in den Ansprüchen 8 und 16 zweckmäßig, wenn die Erfassungsdaten mit der Analysesoftware durch feste Regeln oder durch lernende Algorithmen analysiert werden.

Weitere Vorteile der Erfindung ergeben sich aus der nachfolgenden Beschreibung von zwei Ausführungsbeispielen der Erfindung anhand der FIGUREN 1 bis 5 erläutert. Es zeigen:
FIGUR 1 eine Draufsicht auf eine erste SMD-Fertigungsstraße zur Überwachung einer SMD-Fertigung mittels kontaktloser Abstandsmessung (erstes Ausführungsbeispiel),
FIGUR 2 eine Abstands-Sensormesseinrichtung zur kontaktlosen Abstandsmessung mittels Triangulation in Querschnittsdarstellung,
FIGUR 3 eine Perspektivdarstellung der ersten SMD-Fertigungsstraße zur Überwachung der SMD-Fertigung gemäß der FIGUR 1 mit der Abstands-Sensormesseinrichtung zur kontaktlosen Abstandsmessung mittels Triangulation gemäß der FIGUR 2 außerhalb eines ersten Schablonendrucksystems,
FIGUR 4 eine Funktionseinheit aus der Abstands Sensormesseinrichtung zur kontaktlosen Abstandsmessung gemäß der FIGUR 2 und einer Auswerteeinrichtung,
FIGUR 5 eine Draufsicht auf eine zweite SMD-Fertigungsstraße zur Überwachung einer SMD-Fertigung mittels Kraft-/Abstandsmessung (zweites Ausführungsbeispiel).

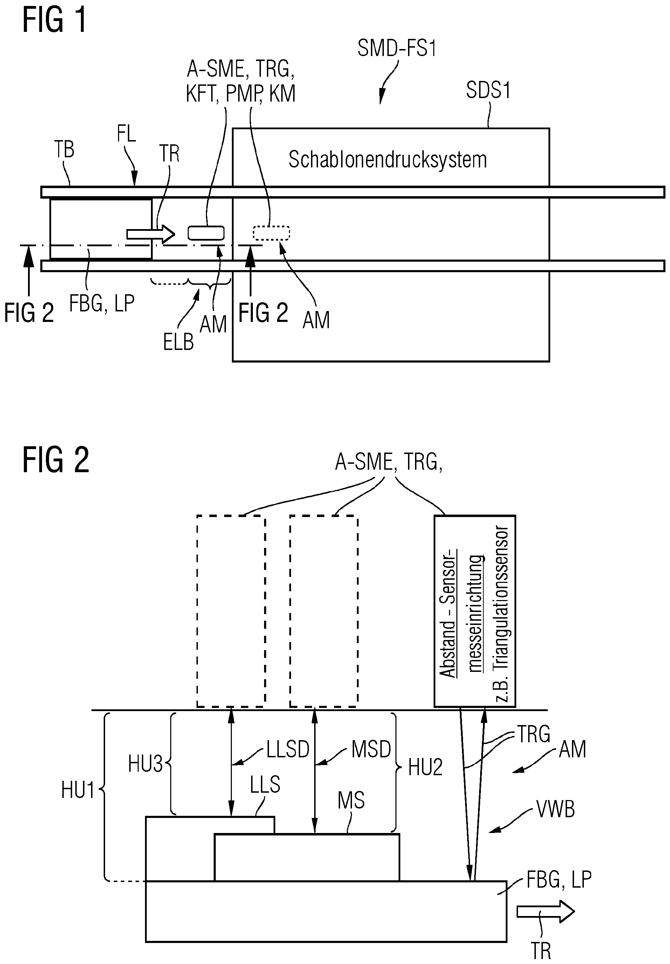

FIGUR 1 zeigt -als ein erstes Ausführungsbeispiel der Erfindung - eine Draufsicht auf eine erste SMD-Fertigungsstraße SMD-FS1 zur Überwachung einer SMD-Fertigung mittels kontaktloser Abstandsmessung AM. Die SMD-Fertigungsstraße SMD-FS1 enthält eine Fertigungslinie FL und ein erstes Schablonendrucksystem SDS1, in das im Zuge der SMD-Fertigung eine Flachbaugruppe FBG, die z.B. als eine Leiterplatte LP ausgebildet sein kann, für eine fertigungslinienbezogene SMD-Bestückung zuführbar ist. Die Flachbaugruppe FBG bzw. die Leiterplatte LP wird dabei bekanntermaßen und vorzugsweise auf einem zur Fertigungslinie FL gehörenden Transportband TB dem ersten Schablonendrucksystem SDS1 zugeführt.

Die kontaktlose Abstandsmessung AM passiert gemäß dem ersten Ausführungsbeispiel mit einer Abstand-Sensormesseinrichtung A-SME, die entweder in einem Einlaufbereich ELB des ersten Schablonendrucksystems SDS1 oder in dem ersten Schablonendrucksystem SDS1 angeordnet ist. Der Einlaufbereich ELB des ersten Schablonendrucksystems SDS1 ist in Transportrichtung TR der Flachbaugruppe FBG, LP der Bereich im Wesentlichen unmittelbar vor dem Schablonendrucksystem SDS1, wenn die Flachbaugruppe FBG, LP dem ersten Schablonendrucksystem SDS1 zugeführt wird und zwar bevor die Flachbaugruppe FBG, LP in das Schablonendrucksystem SDS1 eintritt oder einläuft.

Bei einer derartig konzipierten SMD-Fertigung, wo die einzelnen Fertigungssysteme, von denen in der FIGUR 1 nur das Schablonendrucksystem SDS1 dargestellt ist, mit entsprechend zwischengeschalteten Transportbändern verkettet sind, kann bereits zu Beginn der SMD-Fertigung mit dem Eintreten bzw. Einlaufen der Flachbaugruppe FBG bzw. der Leiterplatte LP in das erste Schablonendrucksystem SDS1 simultan die Eingangsqualität der Flachbaugruppe FBG, LP analysiert werden.

Alternativ zu der Darstellung in der FIGUR 1 ist es auch möglich, dass die erste SMD-Fertigungsstraße SMD-FS1 mehr als eine Fertigungslinie FL und mehr als ein Transportband TB aufweist. So ist es vorstellbar, dass mehrere Flachbaugruppen FBG, LP zu verschiedenen Fertigungslinien FL gehörend, auf unterschiedlichen Transportbändern dem ersten Schablonendrucksystem SDS1 parallel zugeführt werden. In diesem Fall enthält die erste SMD-Fertigungsstraße SMD-FS1 zur Überwachung der SMD-Fertigung, für die kontaktlose Abstandsmessung AM jeweils eine Abstand-Sensormesseinrichtung A-SME pro Fertigungslinie FL.

Die Abstand-Sensormesseinrichtung A-SME ist vorzugsweise derart ausgebildet ist, dass die kontaktlose Abstandmessung AM als Triangulation TRG optisch und winkelbasiert (vgl. FIGUREN 2 bis 4) durchgeführt wird. Alternativ dazu kann die kontaktlose Abstandmessung AM auch mittels Konfokaltechnik KFT konfokal oder auf Prinzipien zur Musterprojektion PMP oder auf Prinzipien zur Streifenprojektion PSP oder Kamera-basiert KM durchgeführt werden.

FIGUR 2 zeigt in einer Querschnittsdarstellung und im Detail wie mit der Abstands-Sensormesseinrichtung A-SME durch eine optische und winkelbasierte Triangulation TRG Abstände kontaktlos gemessen AM werden können. Gemäß dieser Darstellung lassen sich, wenn die Flachbaugruppe FBG bzw. die Leiterplatte LP in der angegebenen Transportrichtung TR in dem Einlaufbereich ELB des ersten Schablonendrucksystems SDS1 die Abstand-Sensormesseinrichtung A-SME passiert, durch die optische und winkelbasierte Triangulation TRG unterschiedliche Abstände zwischen der Abstands-Sensormesseinrichtung A-SME und einer Oberfläche der Flachbaugruppe FBG bzw. der Leiterplatte LP messen. Da diese Oberfläche der Flachbaugruppe FBG, LP durch auftretende Verwölbungen VWB der Flachbaugruppe FBG, LP und/oder unterschiedliche Metallisierungsschichtdicken MSD einer Leiterbahnstrukturen enthaltene Metallisierungsschicht MS auf der Flachbaugruppe FBG, LP oder unterschiedliche Lötstopplackschichtdicken LLSD einer Lötstopplackschicht LLS auf der Flachbaugruppe FBG, LP bestimmt wird, ergeben sich bei der optischen und winkelbasierten Triangulationsmessung TRG die unterschiedlichen Abstände. Diese Abstände korrespondieren zu unterschiedlichen Bauhöhen der Flachbaugruppe FBG, LP und werden im Folgenden als Höhenunterschiede HU1, HU2, HU3 bezeichnet. So gibt ein erster Höhenunterschied HU1 den gemessenen Abstand zwischen der Abstands-Sensormesseinrichtung A-SME und der Oberfläche der Flachbaugruppe FBG, LP an, die durch ein Trägermaterial der Flachbaugruppe FBG, LP ohne die Metallisierungsschicht MS und die Lötstopplackschicht LLS gebildet wird. Ein zweiter Höhenunterschied HU2 gibt den gemessenen Abstand zwischen der Abstands-Sensormesseinrichtung A-SME und der Oberfläche der Flachbaugruppe FBG, LP an, die durch das Trägermaterial der Flachbaugruppe FBG, LP inklusive der Metallisierungsschicht MS gebildet wird, während ein dritter Höhenunterschied HU3 den gemessenen Abstand zwischen der Abstands-Sensormesseinrichtung A-SME und der Oberfläche der Flachbaugruppe FBG, LP angibt, die durch das Trägermaterial der Flachbaugruppe FBG, LP inklusive der Metallisierungsschicht MS und der Lötstopplackschicht LLS gebildet wird. Aufgrund dieser Abstandsdefinitionen lassen sich z.B. durch (i) die ersten Höhenunterschiede HU1 die Verwölbungen VWB auf der Flachbaugruppe FBG, LP, (ii) die zweiten Höhenunterschiede HU2 die unterschiedlichen Metallisierungsschichtdicken MSD auf der Flachbaugruppe FBG, LP und **(iii)** die dritten Höhenunterschieden HU3 die unterschiedlichen Lötstopplackschichtdicken LLSD auf der Flachbaugruppe FBG, LP ermitteln.

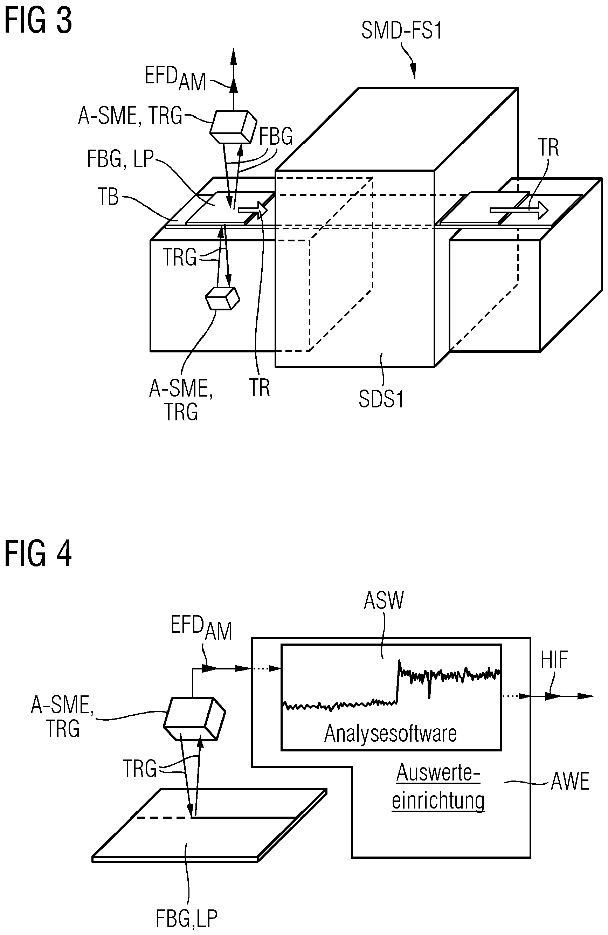

FIGUR 3 zeigt in einer Perspektivdarstellung die ersten SMD-Fertigungsstraße SMD-FS1 zur Überwachung der SMD-Fertigung gemäß der FIGUR 1 mit der im Einlaufbereich ELB des ersten Schablonendrucksystems SDS1 -also außerhalb des ersten Schablonendrucksystems SDS1 - positionierten Abstands-Sensormesseinrichtung A-SME zur kontaktlosen Abstandsmessung AM mittels Triangulation TRG gemäß der FIGUR 2. Wenn die auf dem Transportband RB sich befindende Flachbaugruppe FBG, LP in Transportrichtung TR dem ersten Schablonendrucksystem SDS1 zugeführt wird, scannt die im Einlaufbereich ELB des Schablonendrucksystems SDS1 positionierte Abstands-Sensormesseinrichtung A-SME die Flachbaugruppe FBG, LP zur kontaktlosen Abstandsmessung mittels der Triangulation TRG. Bei dieser Abtastung (Scan) ermittelt die Abstands-Sensormesseinrichtung A-SME, TRG auf der Basis einer punktbezogenen Abstandsmessung Erfassungsdaten EFD_{AM}, die die Höhenunterschiede HU1, HU2, HU3 repräsentieren.

Durch diese punktförmige Abstandsmessung zu einem Punkt können in Verbindung mit dem Weitertransport der Flachbaugruppe FBG, LP als vorteilhafte Weiterbildung ein Linienscan der Flachbaugruppe FBG, LP und entsprechende linienscanbasierte Erfassungsdaten erzeugt werden.

FIGUR 4 zeigt eine Funktionseinheit aus der Abstands-Sensormesseinrichtung A-SME zur kontaktlosen Abstandsmessung gemäß den FIGUREN 2 und 3 sowie einer Auswerteeinrichtung AWE. Im Zuge dieser Funktionseinheit ist die Abstand-Sensormesseinrichtung A-SME mit der Auswerteeinrichtung AWE verbunden und derart ausgebildet, dass die durch das Abtasten der Flachbaugruppe FBG, LP mittels der Triangulation TRG erzeugten Erfassungsdaten EFD_{AM} durch eine Analysesoftware ASW in der Auswerteeinrichtung AWE bezüglich der auftretenden Höhenunterschiede HU1, HU2, HU3 analysiert und Hinweisinformationen HIF für einen Bediener oder einer Prozesssteuerung der SMD-Fertigung für Eingriffe in die SMD-Fertigung generiert werden.

Die Auswerteeinrichtung AWE mit der Analysesoftware ASW derart ausgebildet ist, dass die Hinweisinformationen HIF durch Vergleich der Erfassungsdaten EFD_{AM} von unterschiedlichen Flachbaugruppen FBG, LP, insbesondere aus verschiedenen SMD-Fertigungslinien FL, und daraus sich ergebende Auffälligkeiten der Flachbaugruppe FBG, LP für eine dynamisch Korrektur detektiert, analysiert und/oder gemeldet werden. Die Korrektur kann dabei von dem Bediener oder der Prozesssteuerung vorgenommen werden. Im letztgenannten Fall ist die Auswerteeinrichtung AWE dazu mit der Prozessteuerung verbunden (in der FIGUR 4 nicht explizit dargestellt).

Weiterhin ist die Auswerteeinrichtung AWE mit der Analysesoftware ASW derart ausgebildet ist, dass die Erfassungsdaten EFD_{AM} mit der Analysesoftware ASW durch feste Regeln oder durch lernende Algorithmen analysiert werden.

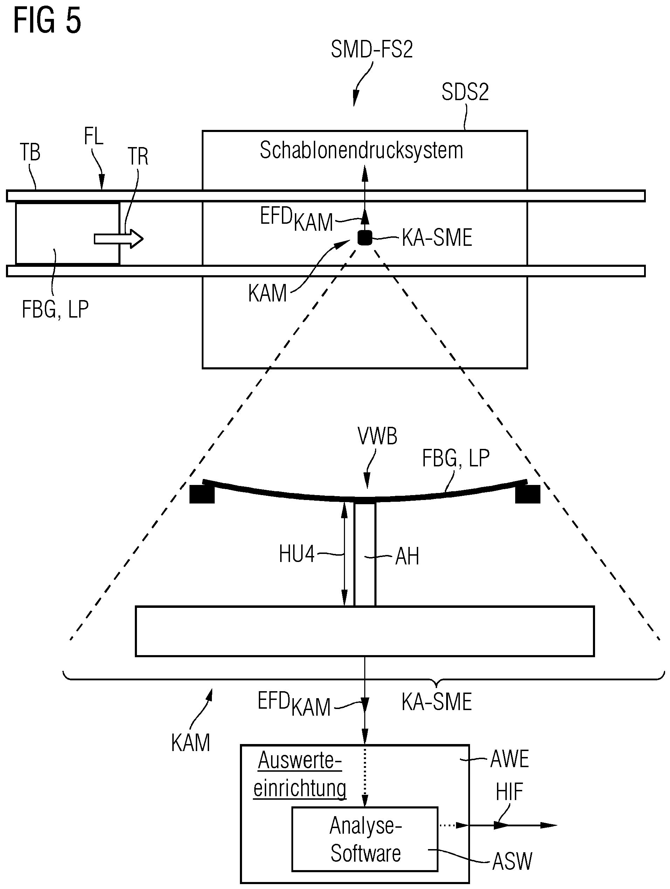

FIGUR 5 zeigt -als ein zweites Ausführungsbeispiel der Erfindung - eine Draufsicht auf eine zweite SMD-Fertigungsstraße SMD-FS2 zur Überwachung einer SMD-Fertigung mittels Kraft-/Abstandsmessung KAM. Die SMD-Fertigungsstraße SMD-FS2 enthält eine Fertigungslinie FL und ein zweites Schablonendrucksystem SDS2, in das im Zuge der SMD-Fertigung die Flachbaugruppe FBG, die z.B. als eine Leiterplatte LP ausgebildet sein kann, für eine fertigungslinienbezogene SMD-Bestückung zuführbar ist. Die Flachbaugruppe FBG bzw. die Leiterplatte LP wird dabei bekanntermaßen und vorzugsweise wieder auf dem zur Fertigungslinie FL gehörenden Transportband TB dem zweiten Schablonendrucksystem SDS2 zugeführt.

Die Kraft-/Abstandsmessung KAM passiert gemäß dem zweiten Ausführungsbeispiel mit einer Kraft-/Abstand-Sensormesseinrichtung KA-SME, die in dem zweiten Schablonendrucksystem SDS2 angeordnet ist. Die Flachbaugruppe FBG, LP wird wieder in der Transportrichtung TR dem zweiten Schablonendrucksystems SDS2 zugeführt.

Auch bei dieser derartig konzipierten SMD-Fertigung, wo die einzelnen Fertigungssysteme, von denen in der FIGUR 5 nur das Schablonendrucksystem SDS2 dargestellt ist, mit entsprechend zwischengeschalteten Transportbändern verkettet sind, kann bereits zu Beginn der SMD-Fertigung mit dem Eintreten bzw. Einlaufen der Flachbaugruppe FBG bzw. der Leiterplatte LP in das zweite Schablonendrucksystem SDS2 simultan die Eingangsqualität der Flachbaugruppe FBG, LP analysiert werden.

Auch hier ist es wieder alternativ zu der Darstellung in der FIGUR 5 möglich, dass die zweite SMD-Fertigungsstraße SMD-FS2 mehr als eine Fertigungslinie FL und mehr als ein Transportband TB aufweist. So ist es vorstellbar, dass mehrere Flachbaugruppen FBG, LP zu verschiedenen Fertigungslinien FL gehörend, auf unterschiedlichen Transportbändern dem zweiten Schablonendrucksystem SDS2 parallel zugeführt werden. In diesem Fall enthält die zweite SMD-Fertigungsstraße SMD-FS2 zur Überwachung der SMD-Fertigung, für die Kraft-/Abstandsmessung KAM jeweils eine Kraft-/Abstand-Sensormesseinrichtung KA-SME pro Fertigungslinie FL.

Die Kraft-/Abstand-Sensormesseinrichtung KA-SME weist für die Kraft-/Abstandmessung KAM eine Abstandshalterung AH für die Flachbaugruppe FBG, LP auf, durch die die Kraft-/Abstandmessung KAM in dem zweiten Schablonendrucksystem SDS2 unterstützt wird. Durch diese Abstandshalterung AH lassen sich bei der Kraft-/Abstandsmessung KAM Verwölbungen VWB der Flachbaugruppe FBG, LP auf einfache Art ermitteln, indem z.B. und vorzugsweise durch die Abstandshalterung AH vierte Höhenunterschiede HU4, hervorgerufen durch die Verwölbungen VWB der Flachbaugruppe FBG, LP, kraft-/abstandmessungsbasiert KAM erfasst werden. Infolge der erfassten vierten Höhenunterschiede HU4 werden die vierten Höhenunterschiede HU4 repräsentierende, kraft-/abstandsmessungsbasierte Erfassungsdaten EFD_{KAM} ermittelt.

Diese kraft-/abstandsmessungsbasierten Erfassungsdaten EFD_{KAM} werden wieder der Auswerteeinrichtung AWE mit der Analysesoftware ASW zugeführt, wo sie analysiert und wo die Hinweisinformationen HIF für den Bediener oder der Prozesssteuerung der SMD-Fertigung für Eingriffe in die SMD-Fertigung generiert werden.

Die Auswerteeinrichtung AWE mit der Analysesoftware ASW ist wieder derart ausgebildet ist, dass die Hinweisinformationen HIF durch Vergleich der Erfassungsdaten EFDK_{AM} von unterschiedlichen Flachbaugruppen FBG, LP, insbesondere aus verschiedenen SMD-Fertigungslinien FL, und daraus sich ergebende Auffälligkeiten der Flachbaugruppe FBG, LP für eine dynamisch Korrektur detektiert, analysiert und/oder gemeldet werden. Die Korrektur kann dabei von dem Bediener oder der Prozesssteuerung vorgenommen werden. Im letztgenannten Fall ist die Auswerteeinrichtung AWE dazu mit der Prozessteuerung verbunden (in der FIGUR 5 nicht explizit dargestellt).

Weiterhin ist die Auswerteeinrichtung AWE mit der Analysesoftware ASW derart ausgebildet ist, dass die Erfassungsdaten EFDK_{AM} mit der Analysesoftware ASW durch feste Regeln oder durch lernende Algorithmen analysiert werden.

## Patentansprüche

1. Verfahren zur Überwachung einer SMD-Fertigung, bei dem im Zuge der SMD-Fertigung mit mindestens eines Fertigungslinie (FL) eine Flachbaugruppe (FBG), insbesondere eine Leiterplatte (LP), für eine fertigungslinienbezogene SMD-Bestückung einem Schablonendrucksystem (SDS1, SDS2) zuführbar ist,
**dadurch gekennzeichnet, dass**
a) Höhenunterschiede (HU1, HU2, HU3) der Flachbaugruppe (FBG, LP), die durch kontaktlose Abstandsmessung (AM) erfassbar sind, in einem Einlaufbereich eines ersten Schablonendrucksystems (SDS1), wenn die Flachbaugruppe (FBG, LP) dem ersten Schablonendrucksystem (SDS1) zugeführt wird, oder in dem ersten Schablonendrucksystem (SDS1) zur Ermittlung von die Höhenunterschiede (HU) repräsentierenden, abstandsmessungsbasierten Erfassungsdaten (EFD_{AM}) erfasst werden oder
b) Höhenunterschiede (HU4) der Flachbaugruppe (FBG, LP), die durch Kraft-/Abstandsmessung (KAM) erfassbar sind, in einem zweiten Schablonendrucksystem (SDS2) zur Ermittlung von die Höhenunterschiede (HU4) repräsentierenden, kraft-/abstandsmessungs-basierten Erfassungsdaten (EFD_{KAM}) erfasst werden.

2. Verfahren nach Anspruch 1, **dadurch gekennzeichnet, dass**
die kontaktlose Abstandmessung (AM) entweder als Triangulation (TRG) optisch und winkelbasiert oder mittels Konfokaltechnik (KFT) konfokal oder auf Prinzipien zur Musterprojektion (PMP) oder auf Prinzipien zur Streifenprojektion (PSP) oder Kamera-basiert (KM) durchgeführt wird.

3. Verfahren nach Anspruch 1 oder 2, **dadurch gekennzeichnet, dass**
die Höhenunterschiede (HU1, HU2, HU3), die durch kontaktlose Abstandsmessung (AM) erfassbar sind, durch Verwölbungen (VWB) der Flachbaugruppe (FBG, LP) und/oder unterschiedliche Metallisierungsschichtdicken (MSD) oder Lötstopplackschichtdicken (LLSD) der Flachbaugruppe (FBG, LP) hervorgerufen werden.

4. Verfahren nach Anspruch 1, **dadurch gekennzeichnet, dass**
die Höhenunterschiede (HU4), die durch die Kraft-/Abstandsmessung (KAM) erfassbar sind, durch Verwölbungen (VWB) der Flachbaugruppe (FBG, LP) hervorgerufen werden.

5. Verfahren nach Anspruch 4, **dadurch gekennzeichnet, dass**
die Kraft-/Abstandmessung (KAM) in dem zweiten Schablonendrucksystem (SDS2) für die Erfassung der Verwölbungen (VWB) durch eine Abstandshalterung (AH) für die Flachbaugruppe (FBG, LP) unterstützt wird.

6. Verfahren nach einem der Ansprüche 1 bis 5, **dadurch gekennzeichnet, dass**
die Erfassungsdaten (EFD_{AM}, EFD_{KAM}) durch eine Analysesoftware (ASW) bezüglich der auftretenden Höhenunterschiede (HU1, HU2, HU3, HU4) analysiert und Hinweisinformationen (HIF) für einen Bediener oder einer Prozesssteuerung der SMD-Fertigung für Eingriffe in die SMD-Fertigung generiert werden.

7. Verfahren nach Anspruch 6, **dadurch gekennzeichnet, dass**
die Hinweisinformationen (HIF) durch Vergleich der Erfassungsdaten (EFD_{AM}, EFD_{KAM}) von unterschiedlichen Flachbaugruppe (FBG, LP), insbesondere aus verschiedenen SMD-Fertigungslinien (FL), und daraus sich ergebende Auffälligkeiten der Flachbaugruppe (FBG, LP) für eine dynamische Korrektur detektiert, analysiert und/oder gemeldet werden.

8. Verfahren nach Anspruch 6 oder 7, **dadurch gekennzeichnet, dass**
die Erfassungsdaten (EFD_{AM}, EFD_{KAM}) mit der Analysesoftware (ASW) durch feste Regeln oder durch lernende Algorithmen analysiert werden.

9. SMD-Fertigungsstraße (SMD-FS1, SMD-FS2) zur Überwachung einer SMD-Fertigung, mit mindestens einer Fertigungslinie (FL) und einem Schablonendrucksystem (SDS1, SDS2), in das im Zuge der SMD-Fertigung eine Flachbaugruppe (FBG), insbesondere eine Leiterplatte (LP), für eine fertigungslinienbezogene SMD-Bestückung zuführbar ist,
**gekennzeichnet durch**
a) eine Abstand-Sensormesseinrichtung (A-SME, TRG, KFT, PMP) zur kontaktlosen Abstandsmessung (AM),
**a1**) mit der Höhenunterschiede (HU1, HU2, HU3) der Flachbaugruppe (FBG, LP) erfasst werden, die durch kontaktlose Abstandsmessung (AM) erfassbar sind,
a2) die entweder in einem Einlaufbereich (ELB) eines ersten Schablonendrucksystems (SDS1), wenn die Flachbaugruppe (FBG, LP) dem ersten Schablonendrucksystem (SDS1) zugeführt wird, oder in dem ersten Schablonendrucksystem (SDS1) angeordnet ist und
a3) die Höhenunterschiede (HU1, HU2, HU3) repräsentierende, abstandsmessungsbasierte Erfassungsdaten (EFD_{AM}) ermittelt, oder
b) eine Kraft-/Abstand-Sensormesseinrichtung (KA-SME) zur Kraft-/Abstandsmessung (KAM),
**b1**) mit der Höhenunterschiede (HU4) der Flachbaugruppe (FBG, LP) erfasst werden, die durch Kraft-/Abstandsmessung (KAM) erfassbar sind,
b2) die in einem zweiten Schablonendrucksystem (SDS2) angeordnet ist und
b3) die Höhenunterschiede (HU4) repräsentierende, kraft-/abstandsmessungsbasierte Erfassungsdaten (EFD_{KAM}) ermittelt.

10. SMD-Fertigungsstraße (SMD-FS1, SMD-FS2) nach Anspruch 9,
**dadurch gekennzeichnet, dass**
die Abstand-Sensormesseinrichtung (A-SME) derart ausgebildet ist, dass die kontaktlose Abstandmessung (AM) entweder als Triangulation (TRG) optisch und winkelbasiert oder mittels Konfokaltechnik (KFT) konfokal oder auf Prinzipien zur Musterprojektion (PMP) oder auf Prinzipien zur Streifenprojektion (PSP) oder Kamera-basiert (KM) durchgeführt wird.

11. SMD-Fertigungsstraße (SMD-FS1, SMD-FS2) nach Anspruch 9 oder 10, **dadurch gekennzeichnet, dass**
die Höhenunterschiede (HU1, HU2, HU3), die durch kontaktlose Abstandsmessung (AM) erfassbar sind, Verwölbungen (VWB) der Flachbaugruppe (FBG, LP) und/oder unterschiedliche Metallisierungsschichtdicken (MSD) oder Lötstopplackschichtdicken (LLSD) der Flachbaugruppe (FBG, LP) sind.

12. SMD-Fertigungsstraße (SMD-FS1, SMD-FS2) nach Anspruch 9,
**dadurch gekennzeichnet, dass**
die Höhenunterschiede (HU4), die durch die Kraft-/Abstandsmessung (KAM) erfassbar sind, Verwölbungen (VWB) der Flachbaugruppe (FBG, LP) sind.

13. SMD-Fertigungsstraße (SMD-FS1, SMD-FS2) nach Anspruch 12,
**dadurch gekennzeichnet, dass**
die Kraft-/Abstand-Sensormesseinrichtung (KA-SME) eine Abstandshalterung (AH) für die Flachbaugruppe (FBG, LP) aufweist, durch die die Kraft-/Abstandmessung (KAM) in dem zweiten Schablonendrucksystem (SDS2) für die Erfassung der Verwölbungen (VWB) unterstützt wird.

14. SMD-Fertigungsstraße (SMD-FS1, SMD-FS2) nach einem der Ansprüche 9 bis 13, **dadurch gekennzeichnet, dass** die Abstand-Sensormesseinrichtung (A-SME) und die Kraft-/Abstand-Sensormesseinrichtung (KA-SME) jeweils mit einer Auswerteeinrichtung (AWE) verbunden und derart ausgebildet sind, dass die Erfassungsdaten (EFD_{AM}, EFD_{KAM}) durch eine Analysesoftware (ASW) in der Auswerteeinrichtung (AWE) bezüglich der auftretenden Höhenunterschiede (HU1, HU2, HU3, HU4) analysiert und Hinweisinformationen (HIF) für einen Bediener oder einer Prozesssteuerung der SMD-Fertigung für Eingriffe in die SMD-Fertigung generiert werden.

15. SMD-Fertigungsstraße (SMD-FS1, SMD-FS2) nach Anspruch 14,
**dadurch gekennzeichnet, dass**
die Auswerteeinrichtung (AWE) mit der Analysesoftware (ASW) derart ausgebildet ist, dass die Hinweisinformationen (HIF) durch Vergleich der Erfassungsdaten (EFD_{AM}, EFD_{KAM}) von unterschiedlichen Flachbaugruppen (FBG, LP), insbesondere aus verschiedenen SMD-Fertigungslinien (FL), und daraus sich ergebende Auffälligkeiten der Flachbaugruppe (FBG, LP) für eine dynamisch Korrektur detektiert, analysiert und/oder gemeldet werden.

16. SMD-Fertigungsstraße (SMD-FS1, SMD-FS2) nach Anspruch 14 oder 15, **dadurch gekennzeichnet, dass**
die Auswerteeinrichtung (AWE) mit der Analysesoftware (ASW) derart ausgebildet ist, dass die Erfassungsdaten (EFD_{AM}, EFD_{KAM}) mit der Analysesoftware (ASW) durch feste Regeln oder durch lernende Algorithmen analysiert werden.
